Europäisches Patentamt

European Patent Office

Office européen des brevets

(19)

(11) Publication number: **0 424 098 A2**

## EUROPEAN PATENT APPLICATION

(12)

(21) Application number: 90311328.0

(22) Date of filing: 16.10.90

(51) Int. Cl.⁵: **C30B 29/02**, C30B 1/02, C22C 27/06

(30) Priority: 17.10.89 JP 268245/89
17.10.89 JP 268246/89
25.10.89 JP 275900/89
13.11.89 JP 292500/89
30.11.89 JP 308964/89

(43) Date of publication of application:
24.04.91 Bulletin 91/17

(84) Designated Contracting States:
DE FR GB

(71) Applicant: TOSOH CORPORATION
4560, Oaza-Tonda Shinnanyo-shi
Yamaguchi 746(JP)

(72) Inventor: Kato, Masatoshi
7-3 Higashiyama-cho
Tokuyama-shi, Yamaguchi(JP)

(74) Representative: Beresford, Keith Denis Lewis
et al
BERESFORD & Co. 2-5 Warwick Court High
Holborn
London WC1R 5DJ(GB)

(54) High temperature electrode material.

(57) A high temperature electrode material is disclosed, comprising a single crystal of chromium metal or an aggregate of large single crystals of chromium metal. An electrode material for use in plasmas is also disclosed, comprising a single crystal of chromium metal or an aggregate of large single crystals of chromium metal.

EP 0 424 098 A2

## HIGH TEMPERATURE ELECTRODE MATERIAL

### FIELD OF THE INVENTION

The present invention relates to electrode materials which show improved corrosion resistance and erosion resistance at high temperatures and are advantageously used as electrodes in industrial machines, e.g., sparkplug electrodes etc., without being melted or eroded even in severe environments in which arcs or sparks may cause considerable metal erosion.

### BACKGROUND OF THE INVENTION

A variety of sparkplugs are used in various kinds of internal combustion engines for industrial use including automobile engines. Conditions under which these sparkplugs are used vary widely depending on the kind of fuel used, but in most cases, the electrodes of the sparkplugs are exposed to high temperature environments in which corrosive media such as S, Cl, Pb, V, etc. are present. such environments are so severe that the electrodes suffer from erosion due to combustion gases flowing at high speeds, undergo fatigue due to thermal cycling caused by the starts and stops of machine operation, and also suffer from erosion due to arcs.

On the other hand, magnetohydrodynamic (MHD) power generation is a method in which electric power is produced by inducing a current by the movement of a high-temperature combustion gas doped with a potassium compound at a high speed along electrodes. One serious problem accompanying this power generation is the short life of the electrodes exposed to such an extreme environment, and electrode materials free of this problem and having improved corrosion resistance, arc resistance, thermal fatigue resistance, and erosion resistance are being developed. Electrode materials proposed so far for use in this application include stainless steels such as SUS 304, SUS 447J1, etc., Pt-base alloys, Ni-base alloys, and others. However, these stainless steels suffer from considerable corrosion at high temperatures and erosion by arcs, while the Ni-base alloys have a problem that they are eroded by arcs or they are almost unusable in high temperature environments in which S and V are present in large quantities. Further, alloys containing noble metals such as Pt are costly, although having good properties.

### SUMMARY OF THE INVENTION

The present inventor has conducted intensive studies in order to overcome the above problems. As a result, the following have now been found. High-purity metallic chromium in the form of single crystal has excellent arc resistance and spark resistance. Of impurities such as Fe, Al, Ni, Si, etc. unavoidably present in metallic chromium, Si exerts a favorable influence on the recrystallization and the arc resistance and spark resistance of the chromium. Incorporation of Co or combined incorporation of Co and Si into chromium is effective in single-crystal formation of the chromium through secondary recrystallization and, at the same time, serves to impart excellent high temperature corrosion resistance and arc resistance and spark resistance to the chromium. Further, a chromium-base alloy which contains at least one metal selected from the group consisting of Al, Ti, Co, Nb, La, Ce, and Sm in an amount of from 0.01 to 10 wt% and in which the remaining part of the alloy is substantially constituted by chromium has excellent corrosion resistance and arc resistance and is suited for use as a high temperature electrode material. The present invention has been completed based on these findings.

It is, therefore, an object of the present invention to provide electrode materials suited for use at high temperatures or in plasmas.

### DETAILED DESCRIPTION OF THE INVENTION

In one aspect of the present invention, a high temperature electrode material is provided, which comprises a single crystal of chromium metal or an aggregate of large single crystals of chromium metal.

Examples of the single crystal of chromium metal or the aggregate of large single crystals of chromium metal, according to this invention, include a single crystal of pure metallic chromium having a high purity, e.g., 99.9% or more, or an aggregate of large single crystals of such pure metallic chromium; a single crystal of a chromium-base alloy containing 0.1 wt% or less of Si or an aggregate of large single crystals of such a chromium-base alloy; a single crystal of a chromium-base alloy containing from 0.01 to 3 wt% of Co or an aggregate of large single crystals of such a chromium-base alloy; a single crystal of a chromium-base alloy containing from 0.01 to 3 wt% of Co and 0.1 wt% or less of Si or an aggregate of large single crystals of such a chromium-base alloy; and the like.

Although these electrode materials may be produced by the conventionally employed pulling method, it is possible to produce the electrode materials of this invention by not such a complicated technique but a simple procedure. That is, a raw metal powder is shaped, for example, by sintering or powder metallurgy, and then allowed to undergo secondary recrystallization by heat treatment, thereby producing the electrode material. The term "aggregate of large single crystals" as used herein means an aggregate of relatively large single crystals having an average crystallite grain diameter of from 0.5 to 5 cm, and this aggregate does not substantially differ in property from the single crystal.

The raw material chromium used to obtain the high temperature electrode material of this invention may be one obtained by either an electrolysis or reduction process. The thus-obtained metallic chromium contains unavoidable impurities such as Fe, Al, Si, etc. as it stands. In the present invention, however, Si of these impurity elements is particularly effective in single-crystal formation, and addition of Co is also very effective, as described above.

The high temperature electrode material of the present invention is obtained from pure metallic chromium having a high purity, e.g., 99.9% or more, or from chromium containing Co and/or Si. The chromium containing Co and/or Si can be obtained by adding Co and/or Si to chromium. The amount of Co added to chromium is from 0.01 to 3 wt%, while Si is added in such an amount that the final content of Si including the Si inevitably contained in the raw material is in the range of from 50 wt ppm to 0.1 wt%. Since Si has inevitably come as an impurity into the raw material (normally in an amount of from 40 to 60 wt ppm at minimum), the effect of Si can be obtained without addition of Si. However, if the amount of Si including that of the impurity Si contained in the chromium exceeds 0.1 wt%, the chromium grain boundary-pinning effect is enhanced too much, making the single-crystal formation difficult. If the amount of Si is below 50 wt ppm, sufficient effect cannot be produced. On the other hand, incorporated amounts of co less than 0.01 wt% result in insufficient nucleation during recrystallization and, hence, no growth of single crystal, while amounts thereof exceeding 3 wt% make the single-crystal formation difficult because the chromium grain boundary-pinning effect is excessively enhanced. The incorporation of either Si or Co produces sufficient effects on single-crystal formation and improvements in arc resistance and spark resistance. However, by combined incorporation of Co and Si in amounts of from 0.01 to 3 wt% and from 50 wt ppm to 0.1 wt%, respectively, single-crystal formation comes to be easier and the arc resistance and spark resistance are greatly improved, as compared with the case in which Co or Si is incorporated singly.

In order to incorporate Si and/or Co into metallic chromium which is to be used as a raw metal for producing the electrode material of this invention and which inevitably contains such impurities as those mentioned above, there can be employed a method in which $Co_2O_3$, $SiO_2$, etc. are mixed beforehand with a raw material, e.g., chromium oxide, used for obtaining the metallic chromium. This is a preferred method, but other suitable techniques for incorporating Co and/or Si can be employed without particular limitations as long as the method used can prevent inclusion of other impurities and give a uniform composition. The thus-obtained chromium preferably is shaped by being powdered and then sintered. The sintering may be conducted according to a commonly employed method such as calcination, hot isostatic pressing (HIP), or the like. It is, however, preferred to employ a sintering process in which the sintered product is in a thermally strained state. The sintering temperature is usually not lower than 1200°C and not higher than the melting point of metallic chromium. The sintering pressure is normally 1000 atms. or more. The sintering time is not particularly limited, but is usually 10 minutes or more.

The chromium shape obtained by the above-described method may be then subjected to heat treatment (secondary recrystallization). This heat treatment is conducted for at least 30 minutes in a reducing atmosphere. The heat treatment temperature is not lower than 1500°C but not higher than the melting point of metallic chromium in the case where neither Co nor Si has been incorporated into the chromium shape, or either Co or Si has been incorporated, and is not lower than 1400°C but not higher than the melting point of metallic chromium in the case where both Co and Si have been incorporated into the chromium shape.

In a more preferred method, the sintered product obtained by the calcination or HIP process is then subjected to plastic processing to thereby make it possible to effect the subsequent heat treatment (secondary recrystallization) under mild conditions. Methods for this plastic processing are not particularly limited, and an ordinarily employed technique such as rolling, forging, extrusion, upsetting, or the like may be used. In the case of rolling, for example, plastic processing is preferably performed at a temperature of about 700°C or lower at a rolling rate of from 30 to 90%. The resulting chromium shape is then subjected to heat treatment (secondary recrystallization) This heat treatment is conducted for at least 30 minutes in a reducing atmosphere at a temperature of not lower than 1300°C, preferably not lower than 1500°C, but not higher than the melting point of metallic chromium if neither Co nor Si has been incorporated in the chromium shape, or either Co or Si has been incorporated, or of not lower than 1200°C but not higher than the melting point of metallic chromium if both Co and Si have been incorporated.

In another aspect of the present invention, there is provided an electrode material for use at high temperatures or in plasmas, which contains chromium and at least one metal selected from, the group consisting of Al, Ti, Co, Nb, La, Ce, and Sm, the total content of the at least one metal in the electrode material being from 0.01 to 10 wt% and the chromium substantially constituting the remaining part of the electrode material.

Since those elements other than chromium are stable when in oxide form, they serve to fix the oxygen present as impurity in the chromium and to stabilize oxides present on the chromium shape surface. The incorporation of these elements also serves to change the state of electrons of the constituent component, and this softens the resulting alloy and improves its processability. If the content of the at least one element is below 0.01 wt%, the resulting material cannot have improved processability and, hence, it is difficult to use the material to produce electrodes of complicated shapes. If the content thereof exceeds 10 wt%, the resulting material cannot have good corrosion resistance, erosion resistance, and arc resistance.

It is preferable to take the greatest care to prevent such impurities as oxygen, nitrogen, silica, carbon, aluminum, etc. from coming into the electrode material, since too large an included amount thereof may likely result in poor processability of the material, occurrence of cracks due to arcs, etc., and impaired corrosion resistance. For this reason, it is preferable that the electrode material of this invention be obtained by using, as raw materials, metallic chromium having a purity as high as, for example, 99% or more and at least one metal selected from the group consisting of Al, Ti, Co, Nb, La, Ce, and Sm (preferably, these metals also have each a purity of 99% or more).

The alloy to constitute the electrode material can be prepared, for example, by subjecting a chromium powder and at least one powdered metal selected from Al, Ti, Co, Nb, La, Ce, and Sm to arc fusion in an inert gas, e.g., argon gas, to give an ingot, and then mechanically processing the ingot by rolling at a temperature of not lower than 200°C. Thus, an electrode material made of the alloy is obtained. The alloying method is not limited to the above example, and other alloying techniques may be employed without particular limitations as long as the method used can prevent inclusion of impurities during alloying. The above-described rolling preferably is conducted at a final rolling rate of 70% or more, because this improves the mechanical strength of the alloy with a tensile elongation being 20% or more.

The thus-obtained electrode material does not suffer from material deterioration ascribable to grain boundaries during processing, and shows good malleability and ductility as well as excellent processability. Therefore, electrodes of complicated shapes and structures can be easily obtained from the electrode material by various processing techniques. For example, the electrode material may be cut into desired shapes and sizes by punch pressing, drawing, etc., and then subjected to welding.

As described above, the electrode materials of the present invention never undergo grain boundary corrosion, grain boundary cracking, etc. even in high-temperature oxidizing environments or high-temperature gaseous environments. In the case where the electrode materials contain Si and/or Co incorporated therein, the electrode materials have improved oxide film performance, are free from oxide film unevenness, which may occur where grain boundaries are present, and hence have extremely good corrosion resistance, erosion resistance, including resistance to erosion by sparks, and arc resistance. These effects are greatly enhanced by the combined incorporation of Si and Co, which produce a synergistic effect.

Therefore, the electrode materials of this invention are useful as high temperature electrode materials for use in a variety of high temperature environments, such as electrodes for use in flame spraying, internal combustion engines, etc., as well as electrodes of sparkplugs for automobile engines and electrodes for MHD power generation.

The present invention is illustrated in more detail with reference to the following examples, which should not be construed to be limiting the scope of the invention.

EXAMPLES 1 TO 3

A metallic chromium powder containing 0.015% Fe, 0.004% Si, 0.007% Al, 0.042% O, and 0.001% N as impurities was preformed, subsequently sintered for 1 hour at temperatures of from 1200 to 1300°C at pressures of from 1200 to 2000 atms., and then heat-treated for 3 hours in a hydrogen-atmosphere furnace at temperatures of from 1500 to 1600°C, thereby obtaining three kinds of chromium electrode materials. The influences of the sintering temperature, sintering pressure, and heat treatment temperature on crystalline state are shown in Table 1. The above-obtained electrode materials were ascertained to be a single crystal or an aggregate of large single crystals by the X-ray back reflection Laue method. Tests for evaluating the performances of these electrode materials were conducted according to the following methods.

Arc Resistance Test

The electrode materials obtained were cut into test pieces and fixed in a 1000°C combustion gas of heavy oil which had been doped with sodium sulfate and vanadium pentoxide. Between each test piece and an opposite electrode, arcs were formed for 10 hours. Thereafter, the state of each test piece was examined, and the results obtained are summarized in Table 1.

Spark Test

Each of the electrode materials was used as an electrode to form sparks 1,000,000 times repeatedly in air at a voltage of 30,000 V. The resulting deterioration of each electrode by the sparks was examined, and the results obtained are shown in Table 1.

MHD Power Generation Practical Test

Each of the electrode materials was fixed in an MHD power generator, and a practical test was conducted under the following conditions. The results obtained are shown in Table 1.

| Gas flow velocity | 900 m/s |
| Electrical conductivity of the gas | 10 |
| Gas temperature | 2500°C or higher |
| Additives to the gas | potassium sulfate and potassium carbonate |
| Fuel | coal |
| Operation time | 50 hours |

EXAMPLES 4 TO 12

To chromium oxide having a purity of 99.99% and containing 0.001% Si as an impurity was added Si and/or Co so as to result in the Si and Co contents as shown in Table 1. The Co was added in the form of $Co_2O_3$ by a wet process in various amounts up to 3 wt%, while the Si was added in the form of $SiO_2$ by a wet process in various amounts up to 0.1 wt% in terms of the content of Si including that originally contained as impurity. The thus-doped chromium oxides were reduced in hydrogen at 1550°C and then pulverized to obtain metallic chromium powders. The metallic chromium powders having various compositions were preformed subsequently sintered for 1 hour at temperatures of from 1200 to 1300°C at pressures of from 1200 to 2000 atms., and then heat-treated for 3 hours in a hydrogen-atmosphere furnace at temperatures of from 1400 to 1600°C, thereby obtaining chromium electrode materials. The influences of the sintering temperature, sintering pressure, and heat treatment temperature on crystalline state are shown in Table 1. The above-obtained electrode materials were ascertained to be a single crystal or an aggregate of large single crystals by the X-ray back reflection Laue method.

5

The thus-obtained electrode materials were subjected to the same arc resistance test, spark test, and MHD power generation practical test as those in Examples 1 to 3. The results obtained are summarized in Table 1.

## EXAMPLES 13 TO 15

The same metallic chromium powder as that used in Example 1 was sintered in the same manner as in Examples 1 to 3, subsequently hot-rolled at 500°C at a rolling rate of 60%, and then heat-treated for 3 hours in a hydrogen-atmosphere furnace at temperatures of from 1400 to 1600°C, thereby obtaining chromium electrode materials. The influences of the sintering temperature, sintering pressure, and heat treatment temperature on crystalline state are shown in Table 1. The above-obtained electrode materials were ascertained to be a single crystal or an aggregate of large single crystals by the X-ray back reflection Laue method.

The thus-obtained electrode materials were subjected to the same arc resistance test, spark test, and MHD power generation practical test as those in Examples 1 and 3. The results obtained are summarized in Table 1.

## EXAMPLES 16 TO 24

The same metallic chromium powders as those used in Examples 4 to 12 were sintered in the same manner as in Examples 1 to 3, subsequently hot-rolled at 500°C at a rolling rate of 60%, and then heat-treated for 3 hours in a hydrogen-atmosphere furnace at temperatures of from 1200 to 1600°C, thereby obtaining chromium electrode materials. The influences of the sintering temperature, sintering pressure, and heat treatment temperature on crystalline state are shown in Table 1. The above-obtained electrode materials were ascertained to be a single crystal or an aggregate of large single crystals by the X-ray back reflection Laue method.

The thus-obtained electrode materials were subjected to the same arc resistance test, spark test, and MHD power generation practical test as those in Examples 1 to 3. The results obtained are summarized in Table 1.

## COMPARATIVE EXAMPLES 1 TO 3

Using the same metallic chromium powder as that used in Examples 1 to 3, electrode materials were prepared in the same manner as in Examples 1 to 3 except that the sintering temperature, sintering pressure, and heat treatment temperature were changed as shown in Table 2. The crystalline state of each electrode material after recrystallization is shown in Table 2.

The thus-obtained electrode materials were subjected to the same arc resistance test, spark test, and MHD power generation practical test as those in Example 1. The results obtained are summarized in Table 2.

## COMPARATIVE EXAMPLES 4 TO 12

Metallic chromium powders having various Si and Co contents as shown in Table 2 were prepared in a manner similar to that in Examples 4 to 12. Using the thus- obtained metallic chromium powders, electrode materials were prepared in the same manner as in Examples 4 to 12 except that the sintering temperature, sintering pressure, and heat treatment temperature were changed as shown in Table 2. The crystalline state of each electrode material after recrystallization is shown in Table 2.

The thus-obtained electrode materials were subjected to the same arc resistance test, spark test, and MHD power generation practical test as those in Examples 1 to 3. The results obtained are summarized in Table 2.

6

## COMPARATIVE EXAMPLES 13 AND 14

Using the same metallic chromium powder as that used in Examples 1 to 3, electrode materials were prepared in the same manner as in Example 13 except that the sintering temperature, sintering pressure, and heat treatment temperature were changed as shown in Table 2. The crystalline state of each electrode material after recrystallization is shown in Table 2. The thus-obtained electrode materials were subjected to the same arc resistance test, spark test, and MHD power generation practical test as those in Examples 1 to 3. The results obtained are summarized in Table 2.

## COMPARATIVE EXAMPLES 15 TO 20

Metallic chromium powders having various Co and Si contents as shown in Table 2 were prepared in a manner similar to that in Examples 4 to 12. Using the thus-obtained metallic chromium powders, electrode materials were prepared in the same manner as in Example 16 except that the sintering temperature, sintering pressure, and heat treatment temperature were changed as shown in Table 2. The crystalline state of each electrode material after recrystallization is shown in Table 2. The thus-obtained electrode materials were subjected to the same arc resistance test, spark test, and MHD power generation practical test as those in Examples 1 to 3. The results obtained are summarized in Table 2.

EP 0 424 098 A2

Table 1

| Example | Sintering temperature (°C) | Sintering pressure (atm) | Heat treatment temperature (°C) | Si content (wt%) | Co content (wt%) | Crystalline state after recrystallization | Arc Resistance Test | | | Spark Test | | MHD Power Generation Practical Test | |
|---|---|---|---|---|---|---|---|---|---|---|---|---|---|
| | | | | | | | Average corrosion loss (mg/cm²·h) | Cracking | Grain boundary corrosion | Average corrosion loss (mg/cm²·h) | Cracking | Average corrosion loss (mg/cm²·h) | Cracking |
| 1 | 1200 | 1800 | 1600 | 0.004 | | giant grains* | 2.9 | not occurred | not occurred | 1.2 | not occurred | 0.1 | not occurred |
| 2 | 1300 | 2000 | 1600 | 0.004 | | single crystal | 2.4 | " | " | 1.2 | " | 0.2 | " |
| 3 | 1300 | 1600 | 1500 | 0.004 | | " | 2.5 | " | " | 1.0 | " | 0.1 or less | " |
| 4 | 1200 | 1800 | 1600 | 0.005 | | giant grains* | 2.9 | " | " | 1.2 | " | 0.2 | " |
| 5 | 1200 | 1800 | 1600 | 0.01 | | single crystal | 2.4 | " | " | 1.2 | " | 0.1 or less | " |
| 6 | 1300 | 1600 | 1500 | 0.05 | | " | 2.5 | " | " | 1.0 | " | 0.1 or less | " |
| 7 | 1200 | 1800 | 1600 | 0.002 | 0.01 | giant grains* | 2.8 | " | " | 1.1 | " | 0.2 | " |
| 8 | 1200 | 1800 | 1600 | 0.002 | 0.5 | single crystal | 2.6 | " | " | 1.1 | " | 0.2 less | " |

Table 1 (cont'd)

| | Sinter-ing temp-rature ($^\circ$C) | Sinter-ing pres-ssure (atm) | Heat treat-ment temp-rature ($^\circ$C) | Si content (wt%) | Co content (wt%) | Crystalline state after recrystalli-zation | Arc Resistance Test | | | Spark Test | | MHD Power Generation Practical Test | |
|---|---|---|---|---|---|---|---|---|---|---|---|---|---|
| | | | | | | | Ave-rage corro-sion loss (mg/cm$^2\cdot$h) | Cra-cking | Grain bound-ary corro-sion | Ave-rage corro-sion loss (mg/cm$^2\cdot$h) | Cra-cking | Ave-rage corro-sion loss (mg/cm$^2\cdot$h) | Cra-cking |
| Eample 9 | 1300 | 1600 | 1500 | 0.002 | 3.0 | single crystal* | 2.3 | not occu-rred | not occu-rred | 1.0 | not occu-rred | 0.1 or less | not occu-rred |
| 10 | 1200 | 1800 | 1400 | 0.005 | 0.01 | giant grains* | 2.2 | " | " | 1.2 | " | 0.1 | " |
| 11 | 1200 | 1800 | 1500 | 0.05 | 1.0 | single crystal | 2.1 | " | " | 1.1 | " | 0.1 or less | " |
| 12 | 1300 | 1600 | 1600 | 0.05 | 3.0 | single crystal | 2.0 | " | " | 0.9 | " | 0.1 or less | " |
| 13 | 1200 | 1800 | 1600 | 0.004 | | single crystal | 2.3 | " | " | 1.0 | " | 0.1 or less | " |
| 14 | 1300 | 1800 | 1400 | 0.004 | | giant grains* | 2.8 | " | " | 1.2 | " | 0.2 | " |
| 15 | 1300 | 2000 | 1400 | 0.004 | | single crystal | 2.2 | " | " | 1.2 | " | 0..2 | " |
| 16 | 1200 | 1800 | 1400 | 0.05 | | single crystal | 2.3 | " | " | 1.0 | " | 0.1 or less | " |

EP 0 424 098 A2

Table 1 (cont'd)

| | Sintering temperature (°C) | Sintering pressure (atm) | Heat treatment temperature (°C) | Si content (wt%) | Co content (wt%) | Crystalline state after recrystallization | Arc Resistance Test | | | Spark Test | | MHD Power Generation Practical Test | |
|---|---|---|---|---|---|---|---|---|---|---|---|---|---|
| | | | | | | | Average corrosion loss (mg/cm²·h) | Cracking | Grain boundary corrosion | Average corrosion loss (mg/cm²·h) | Cracking | Average corrosion loss (mg/cm²·h) | Cracking |
| Example 17 | 1300 | 1800 | 1400 | 0.005 | | giant grains* | 2.8 | not occurred | not occurred | 1.2 | not occurred | 0.2 | not occurred |
| 18 | 1300 | 2000 | 1600 | 0.1 | | single crystal | 2.2 | " | " | 1.2 | " | 0.2 | " |
| 19 | 1200 | 1800 | 1400 | 0.002 | 1.5 | " | 2.4 | " | " | 1.2 | " | 0.1 | " |
| 20 | 1300 | 1800 | 1300 | 0.002 | 0.02 | giant grains* | 2.8 | " | " | 1.2 | " | 0.2 | " |
| 21 | 1300 | 2000 | 1600 | 0.002 | 2.0 | single crystal | 2.2 | " | " | 0.9 | " | 0.1 or less | " |
| 22 | 1200 | 1800 | 1400 | 0.1 | 2.0 | " | 1.8 | " | " | 0.8 | " | 0.1 or less | " |
| 23 | 1300 | 1800 | 1200 | 0.01 | 0.5 | " | 1.9 | " | " | 0.9 | " | 0.1 or less | " |
| 24 | 1300 | 2000 | 1600 | 0.1 | 3.0 | " | 1.8 | " | " | 0.8 | " | 0.1 or less | " |

* "Giant grains" means an aggregate of relatively large single crystals.

Table 2

| | Sintering temperature (°C) | Sintering pressure (atm) | Heat treatment temprature (°C) | Si content (wt%) | Co content (wt%) | Crystalline state after recrystallization | Arc Resistance Test | | Spark Test | | MHD Power Generation Practical Test | |
|---|---|---|---|---|---|---|---|---|---|---|---|---|
| | | | | | | | Average corrosion loss (mg/cm²·h) | Cracking | Grain boundary corrosion | Average corrosion loss (mg/cm²·h) | Cracking | Average corrosion loss (mg/cm²·h) | Cracking |
| Comparative Ex. 1 | 1000 | 1800 | 1600 | 0.004 | | fine grains | 3.9 | ocuurred | occurred | 2.4 | occurred | 0.4 | occurred |
| 2 | 1300 | 1600 | 1400 | 0.004 | | " | 3.8 | " | " | 2.5 | " | 0.5 | " |
| 3 | 1300 | 1100 | 1600 | 0.004 | | " | 4.0 | " | " | 2.4 | " | 0.5 | " |
| 4 | 1000 | 1800 | 1300 | 0.1 | | " | 3.9 | " | " | 2.4 | " | 0.4 | " |
| 5 | 1300 | 1600 | 1600 | 0.2 | | " | 3.8 | " | " | 2.5 | " | 0.5 | " |
| 6 | 1300 | 1600 | 1600 | 0.001 | | " | 4.0 | " | " | 2.8 | " | 0.6 | " |
| 7 | 1000 | 1800 | 1300 | 0.002 | 0.1 | " | 4.2 | " | " | 2.9 | " | 0.7 | " |
| 8 | 1300 | 1400 | 1300 | 0.002 | 0.2 | " | 4.1 | " | " | 2.8 | " | 0.6 | " |
| 9 | 1300 | 1600 | 1600 | 0.002 | 0.001 | " | 4.1 | " | " | 2.8 | " | 0..7 | " |
| 10 | 1000 | 1800 | 1200 | 0.1 | 0.1 | " | 4.1 | " | " | 2.6 | " | 0.4 | " |

EP 0 424 098 A2

Table 2 (cont'd)

| | Sinter-ing temp-rature (°C) | Sinter-ing pres-ssure (atm) | Heat treat-ment temp-rature (°C) | Si content (wt%) | Co content (wt%) | Crystalline state after recrystalli-zation | Arc Resistance Test | | | Spark Test | | MHD Power Generation Practical Test | |
|---|---|---|---|---|---|---|---|---|---|---|---|---|---|
| | | | | | | | Ave-rage corro-sion loss (mg/cm²·h) | Cra-cking | Grain bound-ary corro-sion | Ave-rage corro-sion loss (mg/cm²·h) | Cra-cking | Ave-rage corro-sion loss (mg/cm²·h) | Cra-cking |
| Comparative Ex.11 | 1300 | 1600 | 1600 | 0.2 | 1.0 | " | 3.9 | occu-rred | occu-rred | 2.7 | occu-rred | 0.4 | occu-rred |
| 12 | 1300 | 1600 | 1600 | 0.001 | 4.0 | " | 3.8 | " | " | 2.5 | " | 0.5 | " |
| 13 | 1000 | 2000 | 1100 | 0.004 | | " | 4.3 | " | " | 2.8 | " | 0.5 | " |
| 14 | 1200 | 1800 | 1200 | 0.004 | | " | 4.3 | " | " | 2.8 | " | 0.4 | " |
| 15 | 1000 | 2000 | 1600 | 0.2 | | " | 4.2 | " | " | 2.6 | " | 0.5 | " |
| 16 | 1200 | 1800 | 1200 | 0.005 | | " | 4.3 | " | " | 2.7 | " | 0.4 | " |
| 17 | 1300 | 2000 | 1200 | 0.002 | 0.1 | " | 4.0 | " | " | 2.6 | " | 0.6 | " |
| 18 | 1200 | 1800 | 1300 | 0.002 | 5.0 | " | 4.1 | " | " | 2.5 | " | 0.5 | " |
| 19 | 1000 | 2000 | 1000 | 0.1 | 0.1 | " | 3.9 | " | " | 2.5 | " | 0.5 | " |
| 20 | 1200 | 1800 | 1300 | 0.2 | 0.005 | " | 4.1 | " | " | 2.6 | " | 0.4 | " |

12

The results in Tables 1 and 2 show that the electrode materials of this invention have excellent arc and spark resistance and also exhibit excellent durability when used as electrodes.

### EXAMPLE 25

A mixture of 0.3 g of metallic cobalt having a purity of 99.9% and 300 g of metallic chromium containing 0.015% Fe, 0.003% C, 0.03% 0, 0.004% N, and 0.012% Si as impurities was melted in a 1-atm. argon atmosphere by means of an inert gas arc smelting furnace (Max. 1000 A, 20 V) to obtain an ingot. An alloy piece to be rolled was cut off from the ingot, and then rolled at 400°C at a final rolling rate of 70% by means of a hot rolling apparatus having a roll diameter of 200 mm and a roll rotational speed of 17 rpm. Thus, an electrode material having a composition as shown in Table 3 was obtained. The tensile elongation of this electrode material is shown in Table 3.

The thus-obtained electrode material was subjected to the same arc resistance test and spark test as those in Examples 1 to 3. The results obtained in the arc resistance test are shown in Table 4, while those in the spark test are shown in Table 5.

### EXAMPLES 26 TO 30

Using the same metallic chromium powder as that used in Example 25 and 99.9%-purity powders of Co, La, Nb, Ti, and Ce, electrode materials having compositions shown in Table 3 were obtained in the same manner as in Example 25. The tensile elongations of these electrode materials are shown in Table 3. The thus-obtained electrode materials were subjected to the same tests as those in Example 25, and the results obtained are summarized in Tables 4 and 5.

### COMPARATIVE EXAMPLES 21 TO 23

Using the same metallic chromium powder as that used in Example 25 and 99.9%-purity powders of Co, Nb, and Ti, electrode materials having compositions shown in Table 3 were obtained in the same manner as in Example 25. The tensile elongations of these electrode materials are shown in Table 3, The thus-obtained electrode materials were subjected to the same tests as those in Example 25, and the results obtained are summarized in Tables 4 and 5.

Table 3

| | Alloy composition (wt%) | | | | | Cr and others | Elongation (%) |
|---|---|---|---|---|---|---|---|
| | Co | Ti | Nb | Ce | La | | |
| Example 25 | 0.3 | | | | | 99.7 | 25 |
| Example 26 | 5 | | | | | 95 | 23 |
| Example 27 | | 0.05 | | | | 99.95 | 21 |
| Example 28 | | | | 0.5 | | 99.5 | 27 |
| Example 29 | | | 7 | | | 93 | 22 |
| Example 30 | | | | | 2 | 98 | 24 |
| Comparative Example 21 | | 20 | | | | 80 | 2 |
| Comparative Example 22 | 15 | | | | | 85 | 4 |
| Comparative Example 23 | | | 30 | | | 70 | broken |

Table 4

|  | Average crrosion loss (mg/cm$^2 \cdot$h) | Cracking, grain boundary corrosion | Partial melting by arcs |
|---|---|---|---|
| Example 25 | 2.4 | not occured | not occured |
| Example 26 | 2.9 | not occured | not occured |
| Example 27 | 3.2 | not occured | not occured |
| Example 28 | 3.1 | not occured | not occured |
| Example 29 | 2.8 | not occured | not occured |
| Example 30 | 2.8 | not occured | not occured |
| Comparative Example 21 | 29 | occurred | occurred |
| Comparative Example 22 | 21 | occurred | occurred |
| Comparative Example 23 | 25 | occurred | occurred |

Table 5

|  | Average crrosion loss (mg/cm$^2 \cdot$h) | Cracking, grain boundary corrosion | Partial melting by arcs |
|---|---|---|---|
| Example 25 | 1 or less | not occured | not occured |
| Example 26 | 1.2 | not occured | not occured |
| Example 27 | 1 or less | not occured | not occured |
| Example 28 | 1 or less | not occured | not occured |
| Example 29 | 1.3 | not occured | not occured |
| Example 30 | 1.2 | not occured | not occured |
| Comparative Example 21 | 3.5 | occurred | occurred |
| Comparative Example 22 | 4 | occurred | occurred |
| Comparative Example 23 | 7 | occurred | occurred |

The results in Tables 4 and 5 show that the electrode materials of this invention have excellent arc resistance and spark resistance and, hence, exhibit excellent durability when used as electrodes.

While the invention has been described in detail and with reference to specific embodiments thereof, it will be apparent to one skilled in the art that various changes and modifications can be made therein without departing from the spirit and scope thereof.

**Claims**

1. A high temperature electrode material comprising a single crystal of chromium metal or an aggregate of large single crystals of chromium metal.

2. An electrode material as claimed in claim 1, wherein said single crystal of chromium metal is one member selected from the group consisting of single-crystal pure metallic chromium, a single-crystal chromium-base alloy containing 0.1 wt% or less of Si, a single-crystal chromium-base alloy containing from 0.01 to 3 wt% of Co, and a single-crystal chromium-base alloy containing from 0.01 to 3 wt% of Co and 0.1 wt% or less of Si.

3. An electrode material as claimed in claim 1, wherein said aggregate of large single crystals of chromium metal is one member selected from the group consisting of an aggregate of large single crystals of pure metallic chromium, an aggregate of large single crystals of a chromium-base alloy containing 0.1 wt% or less of Si, an aggregate of large single crystals of a chromium-base alloy containing from 0.01 to 3 wt% of Co, and an aggregate of large single crystals of a chromium-base alloy containing from 0.01 to 3 wt% of Co and 0.1 wt% or less of Si.

4. An electrode material for use in plasmas comprising a single crystal of chromium metal or an aggregate of large single crystals of chromium metal.

5. An electrode material as claimed in claim 4, wherein said single crystal of chromium metal is one member selected from the group consisting of single-crystal pure metallic chromium, a single-crystal chromium-base alloy containing 0.1 wt% or less of Si, a single-crystal chromium-base alloy containing from 0.01 to 3 wt% of Co, and a single-crystal chromium-base alloy containing from 0.01 to 3 wt% of Co and 0.1 wt% or less of Si.

6. An electrode material as claimed in claim 4, wherein said aggregate of large single crystals of chromium metal is one member selected from the group consisting of an aggregate of large single crystals of pure metallic chromium, an aggregate of large single crystals of a chromium-base alloy containing 0.1 wt% or less of Si, an aggregate of large single crystals of a chromium-base alloy containing from 0.01 to 3 wt% of Co, and an aggregate of large single crystals of a chromium-base alloy containing from 0.01 to 3 wt% of Co and 0.1 wt% or less of Si.

7. A high temperature electrode material comprising chromium and at least one metal selected from the group consisting of Al, Ti, Co, Nb, La, Ce, and Sm, the total content of said at least one metal in the electrode material being from 0.01 to 10 wt% and said chromium substantially constituting the remaining part of the electrode material.

8. An electrode material for use in plasmas comprising chromium and at least one metal selected from the group consisting of Al, Ti, Co, Nb, La, Ce, and Sm, the total content of said at least one metal in the electrode material being from 0.01 to 10 wt% and said chromium substantially constituting the remaining part of the electrode material.

9. The use as an electrode material of chromium or a chromium alloy, the alloy consisting essentially of chromium and one or more of Co, Si, Al, Ti, Nb, La, Ce and Sm.

10. The use as an electrode material of chromium or a chromium alloy which has an average crystal size sufficiently large that its corrosion and/or erosion properties do not differ substantially from those of single crystal material.